# FASCICULE DE BREVET EUROPEEN

(11) **EP 1 732 109 B1**
(45) Date de publication et mention de la délivrance du brevet: **08.08.2012**
(21) Numéro de dépôt: 06290900.7
(22) Date de dépôt: 01.06.2006
(51) Int. Cl.: H01L 21/027, H01L 21/3213, H01L 21/28, H01L 21/336, H01L 21/74, H01L 23/367, H01L 29/78, H01L 29/786

(54) **Formation d'un masque sur un circuit électronique intégré**
Herstellung einer Maske auf einer integrierten elektronischen Schaltung
Mask formation over an integrated electronic circuit

(30) Priorité: 09.06.2005 FR 0505883
(43) Date de publication de la demande: 13.12.2006
(73) Titulaire: STMicroelectronics (Crolles 2) SAS, 38920 Crolles (FR); COMMISSARIAT A L'ENERGIE ATOMIQUE, 75015 Paris (FR)
(72) Inventeur: Bustos, Jessy, 38660 Le Touvet (FR); Thony, Philippe, 38134 Saint Joseph de Rivière (FR); Coronel, Philippe, 38530 Barraux (FR)
(74) Mandataire: Boire, Philippe Maxime Charles

(56) Documents cités:
- US-A- 5 981 150
- US-A1- 2003 042 627
- US-A1- 2004 104 448
- SATO T ET AL: "A new substrate engineering for the formation of empty space in silicon (ESS) induced by silicon surface migration" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5 décembre 1999 (1999-12-05), pages 517-520, XP010372210 ISBN: 0-7803-5410-9
- SATO T ET AL: "SON (silicon on nothing) MOSFET using ESS (empty space in silicon) technique for SoC applications" INTERNATIONAL ELECTRON DEVICES MEETING 2001. IEDM. TECHNICAL DIGEST. WASHINGTON, DC, DEC. 2 - 5, 2001, NEW YORK, NY : IEEE, US, 2 décembre 2001 (2001-12-02), pages 37.1.1-37.1.4, XP010575245 ISBN: 0-7803-7050-3

## Description

La présente invention concerne une formation d'un masque sur un circuit électronique intégré. Elle concerne aussi un circuit électronique intégré qui comprend une portion de matériau formant balise de réflexion d'un rayonnement de procédé lithographique.

Divers procédés sont connus pour former une cavité fermée dans un substrat de circuit électronique intégré. Le document IEDM99 (numéro de publication : 0-7803-5413-3 2) décrit un tel procédé, suivant lequel une cavité ouverte est d'abord formée dans le substrat, par gravure à partir d'une surface de celui-ci. Le substrat est ensuite chauffé de façon à provoquer une fermeture de la cavité par déformation du substrat. Lors de ce chauffage, une partie de la matière du substrat proche de la surface de celui-ci se déplace autour de l'ouverture de la cavité, de sorte que cette ouverture est progressivement réduite puis obturée. La cavité est alors fermée et située en profondeur dans le substrat. Pour cette raison, elle est appelée cavité enterrée. A l'issue du chauffage, la surface du substrat est reconstruite à l'emplacement de l'ouverture de la cavité. Elle est de nouveau sensiblement plane dans toute une zone du circuit contenant la cavité.

Le document "SON (silicon on nothing) MOSFET using ESS (empty space in silicon) technique for SoC applications" (Sato T; INTERNATIONAL ELECTRON DEVICES MEETING 2001. IEDM. TECHNICAL DIGEST. WASHINGTON, DC, DEC. 2 - 5, 2001; Pages 37.1.1 - 37.1.4) décrit aussi un tel procédé suivi de l'élaboration d'un circuit MOSFET.

Lorsque l'élaboration du circuit est poursuivie sur le substrat muni de la cavité enterrée, il est difficile de réaliser des éléments du circuit à des positions sur la surface du substrat qui sont déterminées par rapport à la cavité enterrée. Il est possible d'utiliser des repères d'alignement inscrits sur le substrat, mais il est alors nécessaire d'aligner précisément des outils de fabrication du circuit par rapport à ces repères. Un tel alignement est particulièrement long, en particulier lorsqu'il est effectué par itérations successives en mesurant un décalage à chaque itération.

Un but de la présente invention est de permettre de réaliser facilement des éléments de circuit sur un substrat de circuit électronique intégré, à des positions déterminées par rapport à une cavité enterrée dans le substrat.

Pour cela, l'invention propose un procédé de formation d'un masque sur un circuit électronique intégré selon la revendication 1.

Ainsi, selon l'invention, le substrat est chauffé de sorte que la cavité se referme, tout en laissant une déformation de la surface du substrat à l'emplacement de l'ouverture initiale de la cavité. Cette déformation possède la forme d'un enfoncement de la surface du substrat, qui est situé au dessus de la cavité. La cavité est alors devenue enterrée dans le substrat. L'enfoncement de la surface du substrat est rempli d'un matériau qui présente un contraste en réflexion pour un rayonnement de procédé lithographique. La couche de résine est formée sur le circuit, dans une zone de celui-ci qui contient la portion du matériau de remplissage de l'enfoncement. Les paramètres d'exposition de la résine au rayonnement sont sélectionnés de sorte que des portions de résine qui ne sont pas situées au dessus de l'enfoncement sont exposées à une quantité de rayonnement qui est supérieure au seuil de développement de la résine. En effet, ces portions sont exposées à la fois au flux primaire de rayonnement produit par une source de rayonnement externe au circuit, et à un flux secondaire produit par réflexion du flux primaire sur le substrat. Des portions de résine qui sont situées au dessus de l'enfoncement sont principalement exposées à une quantité de rayonnement qui ne correspond qu'au flux primaire, puisque la portion de matériau de remplissage atténue, sinon supprime, le flux secondaire. En fonction de la résine lithographique utilisée, positive ou négative, de la résine ne reste sur le circuit à l'issue du développement que dans une zone du circuit qui est située au dessus de l'enfoncement, ou bien dans une zone du circuit complémentaire de l'enfoncement. La portion de matériau qui remplit l'enfoncement de la surface du substrat sert donc de balise de réflexion du rayonnement lithographique, pour obtenir un masque de résine aligné par rapport à la cavité enterrée.

Un premier avantage d'un procédé de formation de masque selon l'invention provient de la simplicité et la rapidité d'une exécution de ce procédé. En effet, aucune étape d'alignement d'outil par rapport au substrat n'est nécessaire, puisque le masque de résine obtenu est automatiquement aligné par rapport à la cavité enterrée.

Un second avantage d'un procédé de formation de masque selon l'invention provient de sa compatibilité avec des cavités enterrées de dimensions quelconques. En effet, une cavité enterrée qui présente de grandes dimensions parallèlement à la surface du substrat peut être obtenue à partir de plusieurs cavités ouvertes formées à l'étape /a/, à proximité les unes des autres. Le chauffage de l'étape /b/ provoque alors une réunion de ces cavités ouvertes en une unique cavité fermée de grandes dimensions, et l'enfoncement de la surface du substrat qui est simultanément obtenu correspond à l'extension de toute la cavité fermée, parallèlement à la surface du substrat.

Avantageusement, une couche de matériau solide peut être déposée sur le circuit entre les étapes /c/ et /d/, et le procédé peut comprendre en outre l'étape suivante, exécutée après l'étape /f/ :
/g/ graver la couche de matériau solide conformément au masque.
Une portion de la couche solide reste alors sur le circuit, qui est située au dessus de la cavité enterrée lorsque la résine est de type résine lithographique négative, ou qui recouvre le circuit en dehors d'une zone correspondant à la cavité enterrée si la résine est de type positif.

Eventuellement, la cavité fermée peut être remplie au moins partiellement d'un matériau conducteur électriquement. Elle peut alors former un segment de connexion électrique disposé au sein du substrat. La cavité fermée peut aussi être remplie au moins partiellement d'une matière apte à évacuer une chaleur produite lors d'un fonctionnement du circuit. Elle forme alors un segment d'un chemin de refroidissement du circuit.

L'invention concerne aussi un circuit électronique intégré selon la revendication 7.

Eventuellement, le circuit peut comprendre en outre une partie de transistor située au dessus de la cavité selon la direction perpendiculaire à la surface du substrat.

D'autres particularités et avantages de la présente invention apparaîtront dans la description ci-après de deux exemples de mise en oeuvre, en référence aux dessins annexés, dans lesquels :
- les figures 1a-1g sont des vues en coupe d'un circuit électronique intégré illustrant des étapes successives d'un procédé selon l'invention ; et
- la figure 2 illustre une application de l'invention à la réalisation d'un transistor MOS à double grille.

Pour raison de clarté, les dimensions des éléments de circuit représentés sur ces figures ne sont pas en proportion avec leurs dimensions réelles. On désigne par N une direction perpendiculaire à la surface d'un substrat sensiblement plan utilisé pour réaliser le circuit. La direction N est orientée vers le haut des figures, et les mots «sur», «sous», «inférieur» et «supérieur» utilisés dans la suite le sont en référence à cette orientation. En outre, des références identiques sur des figures différentes désignent des éléments identiques, ou qui ont des fonctions identiques.

Enfin, on se limite à décrire dans la suite une succession d'étapes élémentaires de réalisation du circuit électronique intégré, qui permet de reproduire l'invention. Chaque étape élémentaire, qui est considérée comme connue en soi, n'est pas reprise en détail.

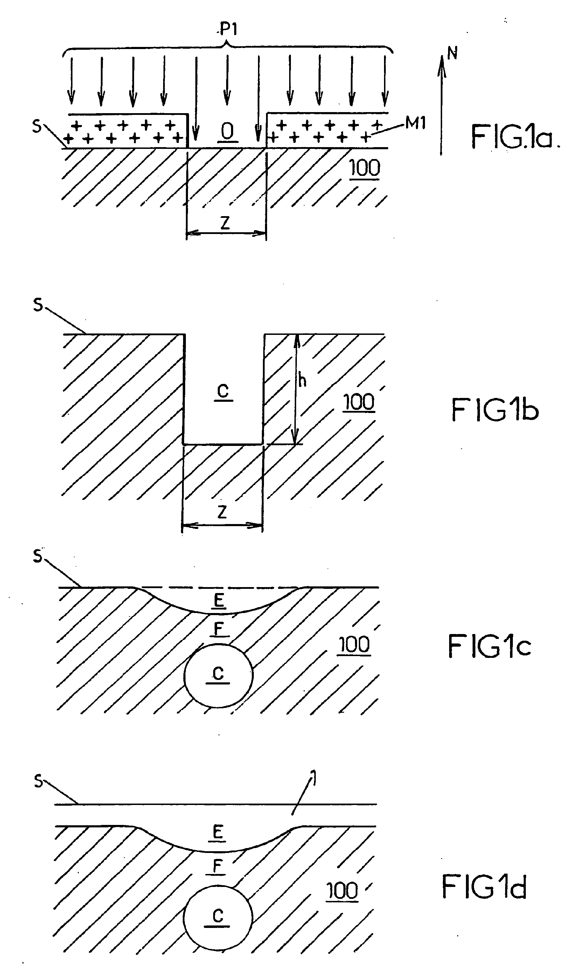

Conformément à la figure 1a, un substrat 100 de circuit électronique intégré en cours d'élaboration est recouvert sur sa surface supérieure S d'un masque de résine lithographique M1. Le substrat 100 peut être en silicium monocristallin, par exemple. Le masque M1 possède une ouverture O située au dessus d'une zone déterminée Z du substrat 100. On procède alors à une gravure du substrat, à l'aide d'un plasma P1 : des ions du plasma P1 sont accélérés et dirigés contre la surface supérieure du circuit, parallèlement à la direction N et en sens opposé à celle-ci. Un tel procédé de gravure est couramment désigné par gravure sèche anisotrope. Une cavité C est ainsi progressivement creusée dans le substrat 100 à partir de la surface S, au droit de l'ouverture O du masque M1 (figure 1b). La cavité C est ouverte au niveau de la surface S et possède une profondeur h déterminée par la durée de l'étape de gravure du substrat 100. Le masque M1 est alors retiré, par exemple par dissolution dans une solution appropriée.

Le circuit est alors chauffé de façon à provoquer une déformation de la surface S du substrat 100 autour de la cavité C. Par exemple, le circuit est chauffé vers 1100°C sous hydrogène, pendant plusieurs minutes. Le matériau du substrat 100 subit alors des forces de capillarité autour de la cavité C, qui provoquent un déplacement de certaines portions de celui-ci de façon à réduire des tensions superficielles présentes sur les parois de la cavité C, notamment au niveau des angles de la cavité C. L'ouverture de la cavité C sur la surface S devient progressivement plus étroite, jusqu'à être complètement obturée par une pellicule F de matériau du substrat 100 (figure 1c). La cavité C est alors fermée et située en profondeur sous la surface S. Pour cette raison, elle est dite cavité enterrée. Sa forme est arrondie. Simultanément, un enfoncement E de la surface S du substrat 100 apparaît au dessus de la cavité C.

De façon connue, la déformation de la cavité C pendant le chauffage dépend de la variation de température subie par celui-ci. Par exemple, si la profondeur initiale h de la cavité C est importante et si la température de chauffage est élevée, plusieurs cavités peuvent apparaître, qui sont superposées selon la direction N. Un enfoncement de la surface S est encore présent au dessus des cavités.

Il est aussi possible de réaliser une cavité enterrée de forme et d'extension quelconque, parallèlement à la surface S du substrat 100. Pour cela, le masque M1 présente plusieurs ouvertures, séparées mais situées à proximité les unes des autres. La gravure du substrat crée alors plusieurs cavités ouvertes distinctes, et le chauffage provoque un retrait du matériau des parois présentes entre deux cavités voisines. Les cavités fusionnent ainsi et une cavité enterrée unique en résulte, qui présente de grandes dimensions. Lorsque les ouvertures du masque M1 sont alignées sur la surface S, la cavité enterrée présente la forme d'un tunnel. Des dimensions d'un tel tunnel peuvent être, par exemple, 10 µm (micromètres) de longueur, parallèlement à la surface S, et 50 µm de hauteur, parallèlement à la direction N. Un enfoncement de la surface du substrat est présent au dessus du tunnel, et son extension parallèlement à la surface S correspond aux dimensions du tunnel.

Une couche 1 est déposée sur le substrat 100, de façon à remplir l'enfoncement E (figure 1d). Le matériau de la couche 1 est sélectionné pour atténuer, ou supprimer, une réflexion d'un rayonnement sur la surface S du substrat 100. Cette fonction de la couche 1 sera décrite en détail plus loin.

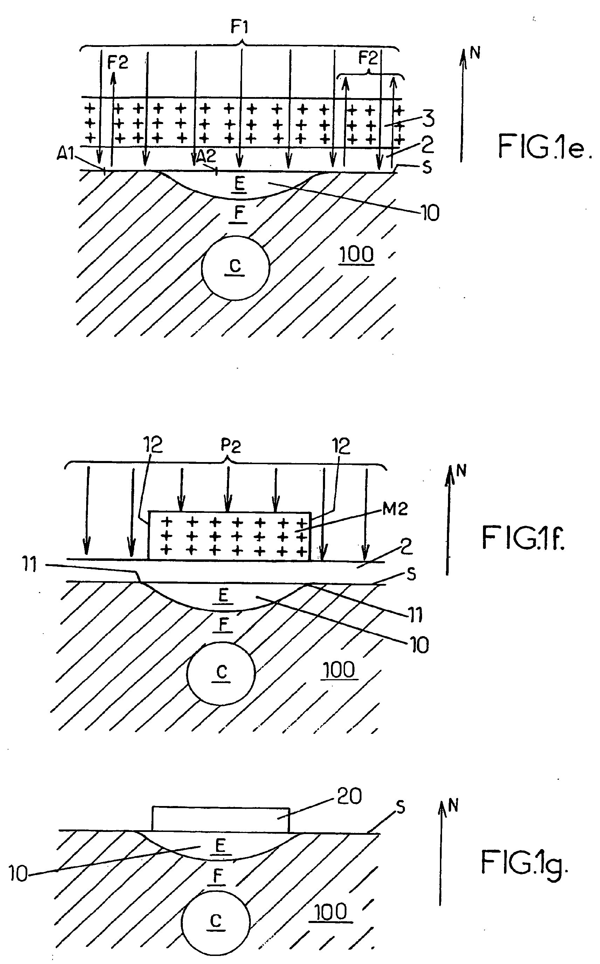

Le circuit est ensuite poli sur sa surface supérieure, de façon à retirer la couche 1 en dehors de l'enfoncement E (figure 1e). A l'issue du polissage, le circuit présente une surface supérieure plane, et une portion résiduelle de la couche 1, référencée 10, ne subsiste que dans l'enfoncement E, c'est-à-dire dans une zone du circuit située au dessus de la cavité C.

On dépose une couche 2 sur le circuit, qui recouvre la portion 10 au dessus de l'enfoncement E et le substrat 100 en dehors de l'enfoncement E. Le matériau de la couche 2 peut être isolant ou conducteur électriquement, en fonction de l'élément de circuit destiné à être réalisé au dessus de la cavité C. Par exemple, la couche 2 peut être en polysilicium, notamment pour réaliser une partie de transistor MOS (pour «Métal-Oxyde-Semiconducteur»). Eventuellement, la couche 2 peut comprendre plusieurs couches élémentaires de matériaux distincts. Le (les) matériau(x) de la couche 2, ainsi que l'épaisseur de celle-ci, sont en outre sélectionnés de sorte que la couche 2 est essentiellement transparente pour le rayonnement dont la portion 10 est destinée à atténuer une réflexion sur le substrat 100. L'épaisseur de la couche 2 peut être, par exemple, 120 nm (nanomètres) environ.

La couche 2 est recouverte à son tour d'une couche continue de résine lithographique 3. La couche 3 présente une épaisseur adaptée pour former un masque de gravure dans la suite du procédé.

On irradie ensuite la couche de résine 3 en dirigeant un flux de rayonnement lithographique F1 (figure 3e) contre la surface supérieure du circuit, parallèlement à la direction N et en sens opposé à celle-ci. Le flux F1 est appelé flux primaire de rayonnement. Le rayonnement utilisé peut être un faisceau d'électrons ayant une énergie cinétique adaptée en fonction de la résine de la couche 3. Le flux F1 traverse la couche 3 et la couche 2, puisque ces couches sont essentiellement transparentes.

Dans une zone du circuit qui ne contient pas l'enfoncement E, le flux primaire F1 traverse les couches 3 et 2, puis atteint la surface S du substrat 100. En un point A1 de la surface S situé en dehors de l'enfoncement E, le flux primaire F1 est réfléchi par le substrat 100 en direction de la surface supérieure du circuit, sous forme d'un flux secondaire de rayonnement F2. Le flux secondaire F2 traverse alors de nouveau la couche de résine 3.

Etant donné le choix du matériau de la couche 1, aucun flux secondaire n'est réfléchi en direction de la surface supérieure du circuit en un point A2 situé dans l'enfoncement E, puisque la portion 10 atténue, sinon supprime, une réflexion du flux de rayonnement F1 sur le substrat 100. Pour cette raison, la couche 1 est appelée BARC, pour «Bottom AntiReflection Coating». Pour cela, le matériau de la couche 1 peut être absorbant vis-à-vis du rayonnement utilisé. Alternativement, le matériau de la couche 1 peut présenter des propriétés de réfraction adaptées de sorte que la portion 10 ait une fonction de revêtement antiréfléchissant pour le rayonnement utilisé. Par exemple, la couche 1 peut être à base de silice (SiO₂) dense, ou d'un mélange de silice et d'un autre oxyde choisi pour augmenter l'absorption et/ou la réfraction du rayonnement.

Ainsi, des portions de la couche de résine 3 qui ne sont pas situées au dessus de l'enfoncement E sont exposées à une quantité de rayonnement qui correspond au flux total F1+F2, alors que des portions de la couche de résine 3 qui sont situées au dessus de l'enfoncement E sont exposées à une quantité de rayonnement qui ne correspond qu'au flux primaire F1. L'intensité du flux primaire F1 et/ou sa durée sont ajustées de sorte que la quantité de rayonnement qui correspond à la somme des flux F1 et F2 est supérieure au seuil de développement de la résine de la couche 3, et de sorte que la quantité de rayonnement qui correspond seulement au flux F1 est inférieure au même seuil.

On développe la couche de résine 3, d'une façon connue, par exemple en utilisant un bain de dissolution. Si la résine de la couche 3 est de type résine lithographique négative, les portions de la couche 3 qui ont été exposées à une quantité de rayonnement correspondant à F1+F2 sont éliminées, alors que les portions de la couche 3 qui ont été exposées à une quantité de rayonnement correspondant seulement au flux primaire F1 subsistent. A l'issue du développement, une portion résiduelle de la couche 3 est présente seulement sur le circuit au dessus de l'enfoncement E. Cette portion de résine présente des dimensions, parallèlement à la surface S, qui sont sensiblement identiques à celles de l'enfoncement E. Elle forme un masque M2 qui est situé au dessus de la cavité fermée C (figure 1f). Ce masque M2 a un bord 12 qui correspond au contour 11 de l'enfoncement E de la surface S du substrat 100.

On grave alors la couche 2 conformément au masque M2 en utilisant un plasma de gravure P2, dirigé contre la surface supérieure du circuit, parallèlement à la direction N et en sens opposé à celle-ci. L'extension de la gravure, parallèlement à la surface S, est déterminée par le bord 12 du masque M2. La couche 2 est ainsi éliminée à l'extérieur de l'enfoncement E, jusqu'à découvrir la surface supérieure du substrat 100 (figure 1g). Une partie de la couche 2, référencée 20, reste sur le circuit au dessus de l'enfoncement E. Le masque M2 est alors entièrement retiré.

Il est entendu que la partie 20 peut être un élément quelconque du circuit, qui doit être situé au dessus de la cavité C. En particulier, la partie 20 peut comprendre un canal et/ou une structure de grille d'un transistor MOS.

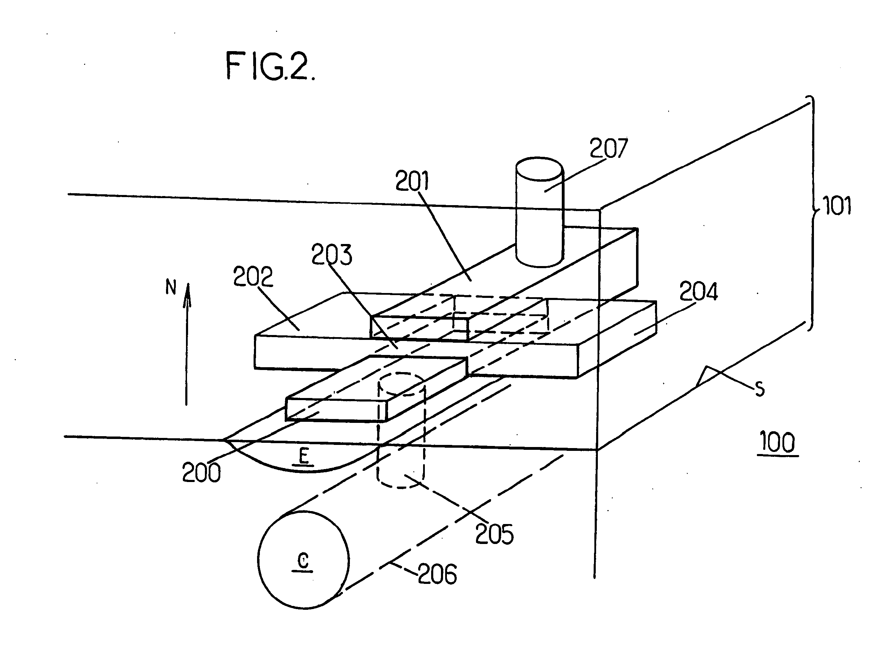

La cavité enterrée C peut être remplie au moins partiellement d'un matériau conducteur électriquement, par exemple pour former une connexion électrique. La figure 2 illustre une telle connexion électrique enterrée, qui relie une partie de grille inférieure 200 d'un transistor MOS. Les références 201, 202, 203 et 204 désignent respectivement une partie de grille supérieure, une zone de source, une zone de canal et une zone de drain du transistor MOS. Les parties de grille 200 et 201, et les zones 202-204 du transistor sont isolées électriquement les unes des autres par des portions de couches isolantes intermédiaires (non représentées). Les parties de grille 200 et 201 sont respectivement situées en dessous et au dessus de la zone de canal 203. La partie de grille 200 est reliée électriquement par une première connexion 205 parallèle à la direction N, et par une seconde connexion 206 réalisée par remplissage de la cavité C avec un matériau conducteur. Eventuellement, le remplissage de la cavité C peut être effectué à partir de la surface S par une cheminée d'accès formée à la place de la connexion 205. Grâce à la disposition de la connexion 206 en profondeur dans le substrat 100, le circuit ne présente pas d'encombrement au niveau de la surface S. La conception du circuit est alors plus facile. La partie de grille 201 peut être reliée électriquement par une connexion 207 disposée à travers le niveau de prémetallisation 101 du circuit, par exemple. Un tel transistor possède donc deux parties de grilles indépendantes, auxquelles des potentiels électriques différents peuvent être appliqués.

Alternativement, la cavité C peut être remplie au moins partiellement d'une matière apte à évacuer une chaleur produite lors d'un fonctionnement du circuit. Un composant du circuit qui produit de la chaleur est alors avantageusement réalisé au dessus de la cavité C, à partir de la partie 20. La matière dont est remplie la cavité C peut être un fluide caloporteur ou un matériau solide conducteur thermiquement.

Il est entendu que de nombreuses adaptations du procédé qui a été décrit en détail ci-dessus peuvent être adoptées, tout en conservant certains au moins des avantages de l'invention. Parmi ces adaptations, on peut citer :
- la résine lithographique de la couche 3 peut être du type positif, de sorte que des portions de résine qui ont été exposées à une quantité de rayonnement inférieure au seuil de développement sont sélectivement éliminées lors du développement ; et
- la couche 2 peut être déposée sur le circuit après que le masque M2 a été formé et développé. Dans ce cas, des parties de la couche 2 qui sont déposées sur le masque M2 sont éliminées avec celui-ci, alors que des parties de la couche 2 qui sont déposées sur le circuit par des ouvertures du masque M2 restent définitivement sur le circuit.

## Revendications

1. Procédé de formation d'un masque (M2) sur un circuit électronique intégré, comprenant les étapes suivantes :
/a/ former au moins une cavité ouverte (C) dans un substrat (100) du circuit, ledit substrat étant réfléchissant pour un rayonnement d'un procédé lithographique (F1) et la cavité s'ouvrant sur une surface (S) sensiblement plane du substrat ;
/b/ chauffer le substrat (100) de façon à provoquer une fermeture de la cavité (C) par déformation du substrat, en créant un enfoncement (E) de la surface du substrat (S) au droit de la cavité fermée, selon une direction perpendiculaire (N) à la surface du substrat (S) ;
/c/ remplir au moins partiellement l'enfoncement de la surface du substrat (E) avec une portion (10) d'un matériau sélectionné de sorte que ladite portion atténue un rayonnement réfléchi par le substrat (100) ;
/d/ former une couche (3) de résine lithographique sur le circuit, au dessus de la surface du substrat (S) ;
/e/ exposer la couche de résine (3) à un flux primaire de rayonnement (F1) correspondant à une quantité de rayonnement inférieure à un seuil de développement de la résine, et déterminé de sorte qu'une quantité de rayonnement correspondant à une somme dudit flux primaire (F1) et d'un flux secondaire (F2) obtenu par réflexion dudit flux primaire sur le substrat (100) en dehors de ladite portion (10) est supérieure au seuil de développement de la résine ; et
/f/ développer la couche de résine (3) de façon à obtenir un masque (M2) ayant un bord (12) correspondant à un contour (11) de l'enfoncement de la surface du substrat (E).

2. Procédé selon la revendication 1, suivant lequel la résine est du type résine lithographique négative, de sorte qu'une portion de la couche de résine (3) reste sur le circuit au dessus de l'enfoncement de la surface du substrat (E), selon la direction perpendiculaire à la surface du substrat (N).

3. Procédé selon la revendication 1 ou 2, suivant lequel une couche (2) de matériau solide est déposée sur le circuit entre les étapes /c/ et /d/, le procédé comprenant en outre l'étape suivante, exécutée après l'étape /f/ :
/g/ graver la couche de matériau solide (2) conformément au masque (M2).

4. Procédé selon l'une quelconque des revendications précédentes, suivant lequel le rayonnement du procédé lithographique (F1) comprend un faisceau d'électrons.

5. Procédé selon l'une quelconque des revendications 1 à 4, suivant lequel la cavité fermée (C) est remplie au moins partiellement d'un matériau conducteur électriquement pour former un segment de connexion électrique disposé au sein du substrat (100).

6. Procédé selon l'une quelconque des revendications 1 à 4, suivant lequel la cavité fermée (C) est remplie d'une matière apte à évacuer une chaleur produite lors d'un fonctionnement du circuit.

7. Circuit électronique intégré comprenant :
- un substrat (100) ayant une surface (S) sensiblement plane en dehors d'un enfoncement (E) de ladite surface,
- une cavité fermée (C) située en profondeur dans le substrat (100), au droit de l'enfoncement de la surface du substrat (E) selon une direction (N) perpendiculaire à ladite surface (S), et
- une portion (10) d'un matériau adapté pour atténuer un rayonnement lithographique réfléchi sur la surface du substrat (F2), ladite portion étant disposée dans l'enfoncement de la surface du substrat (E),
**caractérisé en ce que** la cavité (C) est remplie au moins partiellement d'un matériau conducteur électriquement ou d'une matière apte à évacuer une chaleur produite lors d'un fonctionnement du circuit.

8. Circuit selon la revendication 7, comprenant en outre une partie de transistor (20) située au dessus de la surface du substrat (S), au droit de la cavité (C) selon la direction perpendiculaire à la surface du substrat (N).

## Claims

1. Method for forming a mask (M2) on an integrated electronic circuit, comprising the following steps:
a) forming at least one open cavity (C) in a substrate (100) of the circuit, said substrate being reflective for radiation (F1) of a lithography process and the cavity opening onto a substantially plane surface (S) of the substrate;
b) heating the substrate (100) so as to close off the cavity (C) by deformation of the substrate, creating a depression (E) in the surface of the substrate (S) in line with the closed cavity, along a direction (N) perpendicular to the substrate surface (S);
c) at least partly filling the depression (E) in the substrate surface with a portion (10) of a material selected so that said portion attenuates a radiation reflected by the substrate (100);
d) forming a lithography resist layer (3) on the circuit on top of the substrate surface (S);
e) exposing the resist layer (3) to a primary radiation flux (F1) that corresponds to an amount of radiation below a development threshold of the resist and determined so that an amount of radiation corresponding to the sum of said primary flux (F1) and a secondary flux (F2) obtained by reflection of said primary flux on the substrate (100) outside said portion (10) is above the development threshold of the resist; and
f) developing the resist layer (3) so as to obtain a mask (M2) having an edge (12) that corresponds to an outline (11) of the depression (E) in the substrate surface.

2. Method according to Claim 1, wherein the resist is of the negative lithographic resist type so that a portion of the resist layer (3) remains on the circuit above the depression (E) in the substrate surface, along the direction (N) perpendicular to the surface of the substrate.

3. Method according to Claim 1 or 2, wherein a layer (2) of solid material is deposited on the circuit between steps c) and d), the method further including the following step, carried out after step f):
g) etching the solid material layer (2) in accordance with the mask (M2).

4. Method according to any one of the preceding claims, wherein the radiation (F1) of the lithographic process comprises an electron beam.

5. Method according to any one of Claims 1 to 4, wherein the closed cavity (C) is at least partly filled with an electrically conductive material in order to form an electrical connection segment arranged within the substrate (100).

6. Method according to any one of Claims 1 to 4, wherein the closed cavity (C) is filled with a material capable of extracting heat generated during operation of the circuit.

7. Integrated electronic circuit comprising:
- a substrate (100) having a substantially planar surface (S) outside a depression (E) in said surface;
- a closed cavity (C) located depthwise in the substrate (100) in line with the depression (E) in the surface of the substrate along a direction (N) perpendicular to said surface (S); and
- a portion (10) of a material suitable for attenuating a radiation (F2) reflected on the surface of the substrate, said portion being arranged in the depression (E) in the substrate surface,
**characterized in that** the cavity (C) is at least partly filled with an electrically conductive material or a material capable of extracting heat generated during operation of the circuit.

8. Circuit according to Claim 7, which further includes a part of a transistor (20) located above the substrate surface (S), in line with the cavity (C) along the direction (N) perpendicular to the substrate surface.

## Patentansprüche

1. Verfahren zur Bildung einer Maske (M2) auf einem integrierten elektronischen Schaltkreis, umfassend die folgenden Schritte:
/a/ Bilden von wenigstens einer geöffneten Höhlung (C) in einem Substrat (100) des Schaltkreises, wobei das Substrat für eine Strahlung (F1) eines lithographischen Verfahrens reflektierend ist, und wobei sich die Höhlung auf einer im Wesentlichen ebenen Oberfläche (S) des Substrates öffnet;
/b/ Erwärmen des Substrats (100) derart, dass ein Schließen der Höhlung (C) durch Deformierung des Substrats bewirkt wird, wobei eine Vertiefung (E) der Substratoberfläche (S), ausgerichtet zu der geschlossenen Höhlung entlang einer zu der Substratoberfläche (S) orthogonalen Richtung (N), gebildet wird;
/c/ wenigstens teilweises Auffüllen der Substratoberflächenvertiefung (E) mit einem Stück (10) eines Materials, welches so gewählt ist, dass das Stück eine von dem Substrat (100) reflektierte Strahlung abschwächt;
/d/ Bilden einer Schicht (3) eines lithographischen Harzes auf dem Schaltkreis über der Substratoberfläche (S);
/e/ Aussetzen der Harzschicht (3) einem primären Strahlungsfluss (F1), welcher einer Strahlungsmenge unter einer Entwicklungsschwelle des Harzes entspricht, und welcher derart bestimmt ist, dass eine Strahlungsmenge, die einer Summe des primären Flusses (F1) und eines sekundären Flusses (F2), der durch Reflexion des primären Flusses auf dem Substrat (100) außerhalb des Stücks (10) erhalten wird, entspricht, über der Entwicklungsschwelle des Harzes liegt; und
/f/ Entwickeln der Harzschicht (3) derart, dass eine Maske (M2) mit einem Rand (12), welcher einer Kontur (11) der Substratoberflächenvertiefung (E) entspricht, erhalten wird.

2. Verfahren nach Anspruch 1, wobei das Harz von der Art eines negativen lithographischen Harzes ist, so dass ein Stück der Harzlage (3) auf dem Schaltkreis über der Substratoberflächenvertiefung (E) entlang der zu der Substratoberfläche orthogonalen Richtung (N) verbleibt.

3. Verfahren nach Anspruch 1 oder 2, wobei eine Schicht (2) festen Materials auf dem Schaltkreis zwischen den Schritten /c/ und /d/ angeordnet wird, svobei das Verfahren ferner den folgenden Schritt umfasst, der nach dem Schritt /f/ ausgeführt wird:
/g/ Ätzen der Schicht (2) festen Materials gemäß der Maske (M2).

4. Verfahren nach einem der vorhergehenden Ansprüche, wobei die Bestrahlung des lithographischen Verfahrens (F1) einen Elektronenstrahl umfasst.

5. Verfahren nach einem der Ansprüche 1 bis 4, wobei die geschlossene Höhlung (C) wenigstens teilweise mit einem elektrisch leitfähigen Material gefüllt wird, um einen inmitten des Substrats (100) angeordneten elektrischen Verbindungsabschnitt zu bilden.

6. Verfahren nach einem der Ansprüche 1 bis 4, wobei die geschlossene Höhlung (C) mit einem Material gefüllt wird, welches geeignet ist, eine während eines Betriebs des Schaltkreises erzeugte Wärme abzuführen.

7. Integrierter elektronischer Schaltkreis, umfassend:
- ein Substrat (100) mit einer im Wesentlichen ebenen Oberfläche (S) außerhalb einer Vertiefung (E) der Oberfläche,
- eine geschlossene Höhlung (C), die in einer Tiefe in dem Substrat (100) ausgerichtet zu der Substratoberflächenvertiefung (E) entlang einer zu der Oberfläche (S) orthogonalen Richtung (N) angeordnet ist, und
- ein Stück (10) eines Materials, das geeignet ist, eine auf der Substratoberfläche reflektierte lithographische Strahlung (F2) abzuschwächen, wobei das Stück in der Substratoberflächenvertiefung (E) angeordnet ist,
**dadurch gekennzeichnet, dass** die Höhlung (C) wenigstens teilweise mit einem elektrisch leitfähigen Material oder mit einem Material, das geeignet ist, eine während einer Funktion des Schaltkreises erzeugte Wärme abzuführen, gefüllt ist.

8. Schaltkreis nach Anspruch 7, ferner umfassend einen Transistorteil (20), der über der Substratoberfläche (S) ausgerichtet zu der Höhlung (C) entlang der zu der Substratoberfläche orthogonalen Richtung (N) angeordnet ist.
